# EUROPÄISCHE PATENTSCHRIFT

(11) **EP 2 898 527 B1**
(45) Veröffentlichungstag und Bekanntmachung des Hinweises auf die Patenterteilung: **20.02.2019**
(21) Anmeldenummer: 13758868.7
(22) Anmeldetag: 05.09.2013
(51) Int. Cl.: H01L 21/225, H01L 31/18

(54) **VERFAHREN ZUR DOTIERUNG VON HALBLEITERSUBSTRATEN**
METHOD FOR DOPING SEMICONDUCTOR SUBSTRATES
PROCÉDÉ DE DOPAGE DE SUBSTRATS À SEMI-CONDUCTEUR

(30) Priorität: 21.09.2012 DE 102012018746
(43) Veröffentlichungstag der Anmeldung: 29.07.2015
(73) Patentinhaber: Fraunhofer-Gesellschaft zur Förderung der angewandten Forschung e.V., 80686 München (DE)
(72) Erfinder: ROTHHARDT, Philip, 79119 Freiburg (DE); WOLF, Andreas, 79100 Freiburg (DE); STOFFELS, Thomas, 52972 Aachen (DE); BIRO, Daniel, 79106 Freiburg (DE)
(74) Vertreter: Pfenning, Meinig & Partner mbB
(86) Internationale Anmeldenummer: PCT/EP2013/068387
(87) Internationale Veröffentlichungsnummer: WO 2014/044545

(56) Entgegenhaltungen:
- EP-A1- 1 843 389
- EP-A1- 2 077 587
- WO-A2-2012/022349
- FENNING D. ET AL: "Predictive modeling of the optimal phosphorus diffusion profile in silicon solar cells", THE COMPILED STATE-OF-THE-ART OF PV SOLAR TECHNOLOGY AND DEPLOYMENT : 24TH EUROPEAN PHOTOVOLTAIC SOLAR ENERGY CONFERENCE AND EXHIBITION ; CONFERENCE 21 - 25 SEPTEMBER 2009, EXHIBITION 21 - 24 SEPTEMBER 2009, HAMBURG ; PROCEEDINGS ; EU PVSEC, WIP-RENE, 21. September 2009 (2009-09-21), XP040530068, ISBN: 978-3-936338-25-6
- SCHLOSSER R E ET AL: "Manufacturing of Transparent Selective Emitter and Boron Back-Surface Solar Cells Using Screen Printing Technique", 21ST EUROPEAN PHOTOVOLTAIC SOLAR ENERGY CONFERENCE : PROCEEDINGS OF THE INTERNATIONAL CONFERENCE HELD IN DRESDEN, GERMANY, 4 - 8 SEPTEMBER 2006, WIP RENEWABLE ENERGIES, MÜNCHEN, 4. September 2006 (2006-09-04), Seiten 1119-1124, XP009136533, ISBN: 978-3-936338-20-1
- RAABE R. ET AL: "The development of etch-back processes for industrial silicon solar cells", EU PVSEC PROCEEDINGS : 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6-10 SEPTEMBER 2010, VALENCIA, SPAIN, MUNICH, DE, 6. September 2010 (2010-09-06), XP040530958, ISBN: 978-3-936338-26-3
- DASTGHEIB-SHIRAZI A ET AL: "Effects of process conditions for the n + -emitter formation in crystalline silicon", PHOTOVOLTAIC SPECIALISTS CONFERENCE (PVSC), 2012 38TH IEEE, IEEE, 3. Juni 2012 (2012-06-03), Seiten 1584-1589, XP032258115, DOI: 10.1109/PVSC.2012.6317897 ISBN: 978-1-4673-0064-3
- BACHER-BACHI B. ET AL: "Control of phosphorus diffusion using LYDOP technology for obtaining various phosphorus emitters", THE COMPILED STATE-OF-THE-ART OF PV SOLAR TECHNOLOGY AND DEPLOYMENT : 23RD EUROPEAN PHOTOVOLTAIC SOLAR ENERGY CONFERENCE, EU PVSEC ; PROCEEDINGS OF THE INTERNATIONAL CONFERENCE, HELD IN VALENCIA, SPAIN, 1 - 5 SEPTEMBER 2008, WIP-RENEWABLE ENERGIES, D, 1. September 2008 (2008-09-01), XP040529139, ISBN: 978-3-936338-24-9
- B. S. B. BAZER-BACHI; C. OLIVER; Y. PELLEGRIN; M- GAUTHIER; N. LE QUANG; M. LEMITI: "CO-DIFFUSION FROM BORON DOPED OX- IDE AND POCL3", 26TH EUROPEAN PHOTOVOLTAIC SOLAR ENERGY CONVERENCE AND EXHIBITION, January 2011 (2011-01), pages 1155-1159, XP55425026,

## Beschreibung

Die Erfindung betrifft ein Verfahren zur Dotierung von Halbleitersubstraten mittels eines Diffusionsprozesses, bei dem in einer ersten Belegungsphase auf einer Oberfläche eines Halbleitersubstrats zumindest bereichsweise mindestens eine Dotierstoffquelle abgeschieden wird, anschließend in einer Eintreibphase mindestens ein Dotierstoff in das Halbleitersubstrat diffundiert und in einer zweiten Belegungsphase zumindest bereichsweise auf dem Halbleitersubstrat die mindestens eine Dotierstoffquelle bei gleichzeitiger Diffusion von mindestens einem Dotierstoff in das Halbleitersubstrat erneut abgeschieden wird. Bei diesem Verfahren ist dabei die Dotierstoffkonzentration im oberflächennahen Bereich unabhängig von der Diffusionstiefe des Dotierstoffs einstellbar. Die Erfindung betrifft ebenso derart dotierte Halbleitersubstrate.

EP 2 077 587 A1 (KYOCERA CORP [JP]) 8. Juli 2009 (2009-07-08) betrifft ein Verfahren zur Herstellung eines Solarzellen Elements.

Dotierte Bereiche können unterschiedlichste Aufgaben in einer Solarzelle wahrnehmen, hier seien als Beispiel phosphor-dotierte Bereiche aufgeführt.

Bei p-Typ-Solarzellen dient die Phosphordotierung zur Ausbildung des Emitters, während sie bei n-Typ-Zellen als front-surface-field (FSF) oder als backsurface-field (BSF) dienen kann. Jede dieser Anwendungen stellt andere Anforderungen z.B. bezüglich Kontaktierbarkeit und Ladungsträger-Rekombination der Hochdotierung. Deshalb muss auch das Dotierprofil angepasst werden.

Aktuelle Prozesse zur Dotierung laufen meist wie folgt ab: Die Wafer werden in einer N₂ Atmosphäre in den Ofen eingebracht und dann auf eine bestimmte Temperatur aufgeheizt. Dann folgt ein Temperaturplateau von ca. 20-40 Minuten bei dem neben Stickstoff weitere Reaktionsgase, z.B. POCl₃, BBr₃, BCl₃, O₂ und H₂O in den Ofen eingeleitet werden (A. Cuevas, "A good recipe to make silicon solar cells," presented at Proceedings oft he 22nd IEEE Photovoltaic Specialists Conference, Las Vegas, Nevada, USA, 1991). In dieser sogenannten Belegungsphase bildet sich ein Silicatglas auf der Oberfläche des Wafers. Dieses dient während des gesamten Prozesses als Dotierstoffquelle. Nach diesem ersten Plateau folgt meist ein zweites Plateau, das häufig bei der gleichen Temperatur liegt. In dieser sogenannten Eintreibphase wird der Atmosphäre kein zusätzlicher Dotierstoffprecursor, z.B. POCl₃ oder BBr3 zugeführt. Hier diffundiert einerseits Doteristoff aus dem Silicatglas in den Wafer. Andererseits diffundiert auch Dotierstoff, der bereits während der Belegphase in den Wafer eindiffundiert wurde, tiefer in den Wafer. Je nach gewählten Prozessparametern und Diffusionsmechanismen des verwendeten Dotierstoff bildet sich im allgemeinen z.B. ein Gauß- oder Fehlerfunktion-ähnliches Profil oder ein sogenanntes Kink and tail Profil (bei Phosphordotierung) aus. Wird nun ein anderes Dotierprofil gewünscht, können die unterschiedlichsten Parameter, z.B. Temperatur oder Gasflüsse, angepasst werden. All diesen Anpassungen ist aber gemein, dass damit sowohl die Oberflächenkonzentration als auch die Tiefe des Dotierprofils verändert werden, auch wenn nur die Veränderung eines Parameters gewünscht ist.

Auch aktuelle Ansätze zur Co-Diffusion, also zur simultanen Erzeugung von p-Dotierung und n-Dotierung in einem Hochtemperaturschritt, weisen die oben dargestellte Limitierung auf. (B. S. B. Bazer-Bachi. C. Oliver, Y. Pellegrin, M-Gauthier, N. Le Quang, M. Lemiti, "CO-DIFFUSION FROM BORON DOPED OXIDE AND POCL3," presented at 26th European Photovoltaic Solar Energy Conference and Exhibition, 2011). Hier wird vor dem Diffusionsprozess einseitig eine borhaltige Dotierquelle auf eine Seite des Wafer aufgebracht und der Wafer dann anschließend einer POCl₃-Atmosphäre ausgesetzt, wodurch der Wafer auf der einen Seite mit Bor und auf der anderen Seite mit Phosphor dotiert wird. Dabei wird der erste Teil des Prozesses unter Stickstoff bzw. leicht oxidierender Atmosphäre gefahren. Die POCl₃-Atmosphäre wird erst zum Ende des Prozesses eingeleitet. Somit kann ermöglicht werden, dass für die Bordiffusion ein höheres thermisches Budget als für die Phosphordotierung zur Verfügung steht. Dies wird benötigt, da die effektive Diffusivität für Bor sehr viel kleiner als die für Phosphor ist. Auch hier wird die Dotierung jedoch nur durch eine einzige Belegphase aufgebracht, so dass eine getrennte Einstellung von Oberflächenkonzentration und Dotiertiefe nicht möglich ist.
Ausgehend hiervon war es Aufgabe der vorliegenden Erfindung, ein Dotierungsverfahren bereitzustellen, mit dem die Dotierungskonzentration an der Oberfläche und die Tiefe des Dotierprofils eingestellt werden kann. Gleichzeitig soll der Prozess einfach handhabbar und von kurzer Dauer sein. Auch die Anwendbarkeit als Co-Diffusionsprozess sollte gegeben sein.
Diese Aufgabe wird durch das Verfahren zur Dotierung mit den Merkmalen des Anspruchs 1 gelöst. Die weiteren abhängigen Ansprüche zeigen vorteilhafte Weiterbildungen auf.
Erfindungsgemäß wird ein Verfahren zur Dotierung von Halbleitersubstraten mittels eines Diffusionsprozesses bereitgestellt, bei dem
a) in einer ersten Belegungsphase auf einer Oberfläche eines Halbleitersubstrats zumindest bereichseise mindestens eine Dotierstoffquelle abgeschieden wird,
b) in einer Eintreibphase mindestens ein Dotierstoff in das Halbleitersubstrat diffundiert,
c) in einer zweiten Belegungsphase zumindest bereichsweise auf dem Halbleitersubstrat die mindestens eine Dotierstoffquelle bei gleichzeitiger Diffusion von mindestens einem Dotierstoff in das Halbleitersubstrat erneut abgeschieden wird.

Besonderes Merkmal des erfindungsgemäßen Verfahrens ist es dabei, dass die Diffusionstiefe des Dotierstoffs über den Gasfluss der Dotierstoffquelle in der ersten Belegungsphase und die Dotierstoffkonzentration im oberflächennahen Bereich des Halbleitersubstrats über den Gasfluss der Dotierstoffquelle in der zweiten Belegungsphase eingestellt wird. Über die Gasflüsse kann damit die Konzentration der Dotierstoffquelle, die sich auf dem Halbleitersubstrat abscheidet, eingestellt werden.

Der vorliegenden Erfindung liegt somit der Gedanke zugrunde, die getrennte Einstellung von Oberflächenkonzentration und Diffusionstiefe mittels einer zweiten Belegungsphase am Ende des Prozesse zu erreichen.

Vorzugsweise besteht das Halbleitersubstrat aus Silizium, wobei grundsätzlich auch die Übertragung auf andere Halbleiter möglich ist.

Die erste Belegungsphase findet dabei am Prozessanfang statt, wobei hier eine Dotierstoffquelle auf dem Halbleitersubstrat abgeschieden wird. Durch die Variation des Gasflusses der Dotierstoffquelle oder des Dotierstoffprecursors kann die Menge des abgeschiedenen Dotierstoffs auf dem Halbleitersubstrat und damit auch die Tiefe der Dotierung, sowie die Gesamtdotierung des Halbleitersubstrats eingestellt werden.

Vorzugsweise wird beim erfindungsgemäßen Verfahren
a) im oberflächennahen Bereich des Halbleitersubstrats bis zu einer Tiefe, gemessen von der Oberfläche, von 5 nm eine Dotierstoffkonzentration von über 1.5·10²⁰ Atome/cm³, bevorzugt von über 3·10²⁰ Atome/cm³,
b) im Bereich einer Tiefe, gemessen von der Oberfläche, von 5 nm bis 100 nm eine Dotierstoffkonzentration von über 10¹⁷ Atome/cm³ und
c) im Bereich einer Tiefe, gemessen von der Oberfläche, von 100 bis 400 nm eine Dotierstoffkonzentration von 10²⁰ Atome/cm³ bis 10¹⁷ Atome/cm³, bevorzugt im Bereich von 10¹⁹ Atome/cm³ bis 10¹⁷ Atome/cm³ erzeugt.

Die erste Belegungsphase erfolgt bevorzugt bei einer Temperatur im Bereich von 680°C bis 950°, besonders bevorzugt bei einer Temperatur von 750°C bis 850°C. Die erste Belegungsphase dauert hierbei bevorzugt von 5 bis 50 Minuten, besonders bevorzugt von 10 bis 30 Minuten. Es kann eine oxidierende Atmosphäre oder auch eine Inertgas-Atmosphäre, zum Beispiel Stickstoff, eingesetzt werden.
Im Anschluss an die erste Belegungsphase erfolgt eine Eintreibphase, der eine Temperaturbehandlung des Halbleitersubstrats erfolgt, so dass der Dotierstoff weiter in das Halbleitersubstrat eindiffundieren kann. Die Temperaturbehandlung erfolgt dabei vorzugsweise bei Temperaturen im Bereich von 800°C bis 1000°C, besonders bevorzugt bei Temperaturen im Bereich von 850°C bis 950°C. Die Dauer der Eintreibphase liegt bevorzugt im Bereich von 30 bis 240 Minuten, besonders bevorzugt im Bereich von 45 bis 150 Minuten. Auch bei der Eintreibphase wird eine oxidierende, Atmosphäre, eingesetzt. Eine oxidierende Atmosphäre bewirkt hierbei eine Umwandlung der Dotierstoffquelle, was zu einer Hemmung der weiteren Diffusion in das Halbleitersubstrat führen kann. Dies führt dazu, dass die Dotierstoffkonzentration im oberflächennahen Bereich des Halbleitersubstrats zunächst gesenkt wird, während der im Halbleitersubstrat befindliche Dotierstoff tiefer in das Halbleitersubstrat eingetrieben werden kann.
Im Anschluss folgt dann eine zweite Belegungsphase, in der wiederum ein Dotierstoff in die Atmosphäre eingebracht wird. Der Dotierstoff bzw. der Dotierstoff-Precursor diffundiert durch das bereits aufgewachsene Silikatglas zum Halbleitersubstrat. Da dieser Schritt kurz vor Prozessende durchgeführt wird, hat der Dotierstoff nur eine geringe Zeit, um in das Halbleitersubstrat einzudiffundieren und verbleibt somit im oberflächennahen Bereich des Halbleitersubstrats. Auch hier wird mithilfe des Gasflusses des Dotierstoffs bzw. Dotierstoff-Precursors zunächst die Menge des abgeschiedenen Dotierstoffs beeinflusst und damit auch die Dotierstoffkonzentration im oberflächennahen Bereich des Halbleitersubstrats bestimmt.
Vorzugsweise erfolgt die Temperaturbehandlung in der zweiten Belegungsphase bei Temperaturen von 700°C bis 950°C, besonders bevorzugt 800°C bis 900°C. Die zweite Belegungsphase hat bevorzugt eine Dauer von 5 bis 60 Minuten, besonders bevorzugt von 10 bis 30 Minuten. Als Atmosphäre können hier sowohl eine inerte, als auch eine oxidierende Atmosphäre eingesetzt werden.

Da sowohl die Dotierstoffkonzentration im oberflächennahen Bereich, als auch die Diffusionstiefe des Dotierstoffs durch eine Veränderung der Gasflüsse in der ersten und zweiten Belegungsphase eingestellt werden, ist es möglich, das thermische Budget des Prozesses unverändert zu lassen. So kann dieser Diffusionsprozess auch in Co-Diffusionsprozessen, zum Beispiel mit dotierten Silikatgläsern, Anwendung finden.

Eine weitere erfindungsgemäße Variante sieht vor, dass ein unverändertes thermisches Budget nicht notwendig ist, weswegen dann die Diffusionstiefe des Dotierstoffs auch über die Erhöhung des thermischen Budgets vor der zweiten Belegungsphase eingestellt werden kann.

Eine weitere bevorzugte Variante sieht vor, dass die erste Belegungsphase während des Aufheizens des Halbleitersubtrates erfolgt. Diese Aufheizphase kann beispielsweise von Raumtemperatur bis zu Temperaturen von 700°C bis 900°C liegen. Dadurch kann die Prozessdauer signifikant verkürzt werden, da die komplette Zeit der ersten Belegungsphase in die Aufheizphase verschoben wird. Es ist aber ebenso möglich, dass die erste Belegungsphase nach Erreichen einer Temperatur im Bereich von 750°C bis 850°C erfolgt.

Eine weitere bevorzugte Variante sieht vor, dass das Abscheiden der Dotierstoffquelle vor dem Einbringen des Halbleitersubstrates in den Diffusionsofen erfolgt. Der Hochtemperaturprozess besteht dann nur noch aus der Eintreibphase und der zweiten Belegungsphase.

Es ist weiter bevorzugt, dass in den einzelnen Phasen, d.h. den Belegphasen und der Eintreibphase neben der Dotierstoffquelle weitere Gase, insbesondere Stickstoff und/oder Sauerstoff und/oder Wasserdampf eingeleitet werden. So kann in einer oxidierenden Atmosphäre die Dotierstoffquelle ein Precursor eines Dotierstoffs sein, so dass durch den Sauerstoff in der oxidierenden Atmosphäre eine Umwandlung der Dotierstoffquelle in den Dotierstoff erfolgt.

Als Halbleiter ist insbesondere Silizium bevorzugt. Für die Dotierung mit Phosphor ist als Dotierstoffquelle POCl₃ und/oder PH₃ bevorzugt. Für die Dotierung mit Bor ist als Dotierstoffquelle BBr₃ und/oder B₂H₆ bevorzugt.

Eine weitere bevorzugte Variante sieht vor, dass vor der ersten Belegungsphase auf einer Oberfläche des Halbleitersubstrats ein erster Dotierstoff und auf der gegenüberliegenden Oberfläche des Halbleitersubstrats ein sich vom ersten Dotierstoff unterscheidender, zweiter Dotierstoff abgeschieden wird. In der Eintreibphase werden dann der erste und der zweite Dotierstoff in das Halbleitersubstrat diffundieren. Diese Verfahrensweise bietet sich für die Vorder- und Rückseitendotierung mit Bor und Phosphor an.

Erfindungsgemäß wird ebenso ein dotiertes Halbleitersubstrat, das nach dem zuvor beschriebenen Verfahren hergestellt wurde, bereitgestellt. Das Halbleitersubstrat weist dabei
a) im oberflächennahen Bereich bis zu einer Tiefe, gemessen von der Oberfläche, von 5 nm eine Dotierstoffkonzentration von über 1.5·10²⁰ Atome/cm³,
b) im Bereich einer Tiefe, gemessen von der Oberfläche, von 5 nm bis 100 nm eine Dotierstoffkonzentration von über 10¹⁷ Atome/cm³ und
c) im Bereich einer Tiefe, gemessen von der Oberfläche, von 100 bis 400 nm eine Dotierstoffkonzentration von 10²⁰ Atome/cm³ bis 10¹⁷ Atome/cm³ auf.

Vorzugsweise weist das dotierte Halbleitersubstrat
a) im oberflächennahen Bereich bis zu einer Tiefe, gemessen von der Oberfläche, von 5 nm eine Dotierstoffkonzentration von über 3·10²⁰ Atome/cm³,
b) im Bereich einer Tiefe, gemessen von der Oberfläche, von 5 nm bis 100 nm eine Dotierstoffkonzentration von über 10¹⁷ Atome/cm³ und
c) im Bereich einer Tiefe, gemessen von der Oberfläche, von 100 bis 400 nm eine Dotierstoffkonzentration von 10¹⁹ Atome/cm³ bis 10¹⁷ Atome/cm³ auf.

Anhand der nachfolgenden Figuren und Beispiele soll der erfindungsgemäße Gegenstand näher erläutert werden, ohne diesen auf die hier gezeigten spezifischen Ausführungsformen einschränken zu wollen.

Fig. 1 zeigt ein Diagramm zur Darstellung des Dotierstoffprofils gemäß dem

### Stand der Technik.

Fig. 2 zeigt ein Diagramm zur Einstellung der Dotierstoffkonzentration im oberflächennahen Bereich während der zweiten Belegungsphase gemäß der vorliegenden Erfindung.

Fig. 3 zeigt ein Diagramm zur Veränderung der Diffusionstiefe des Dotierstoffs in der ersten Belegungsphase gemäß der vorliegenden Erfindung.

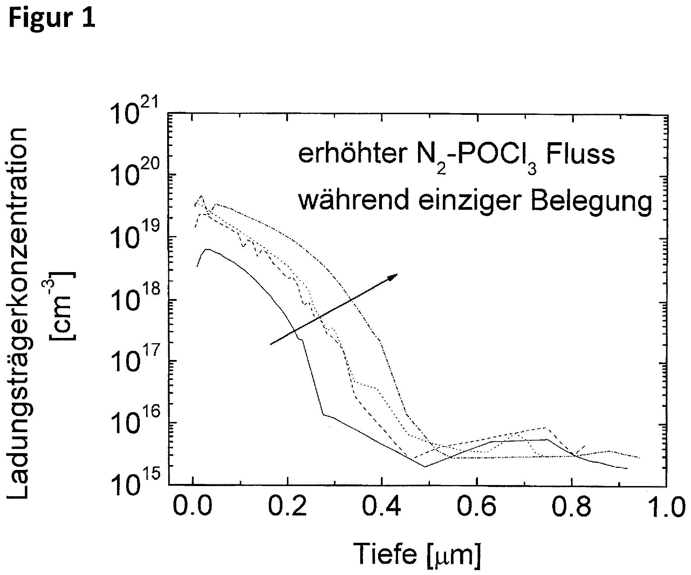

In Fig. 1 wird anhand eines Diagramms beschrieben, wie sich die Konzentration des Dotierstoffs in den oberflächennahen Bereichen des Halbleitersubstrats und die Diffusionstiefe des Dotierstoffs im Halbleitersubstrat gleichzeitig verändern. Durch die Erhöhung des Gasflusses der Dotierstoffquelle (hier POCl₃) kommt es zur gleichzeitigen Änderung der Dotierstoffkonzentration in den oberflächennahen Bereichen und der Diffusionstiefe des Dotierstoffs. Ein getrenntes Einstellen dieser beiden Parameter ist somit gemäß dem Stand der Technik nicht möglich.

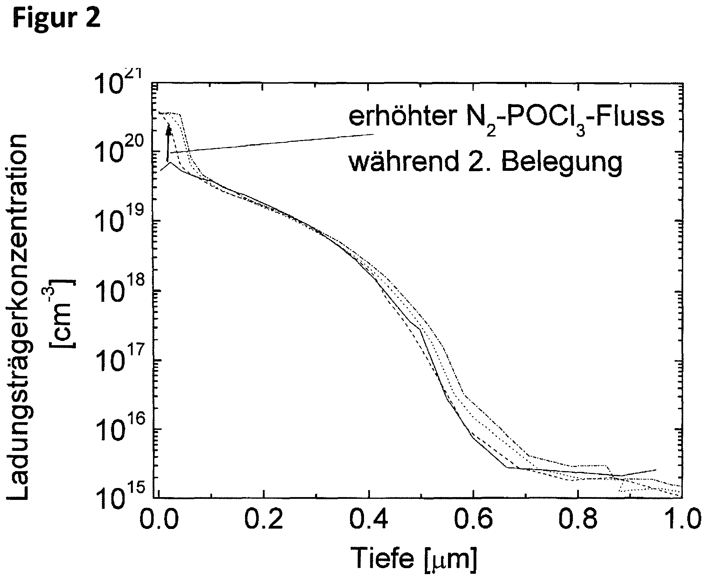

In Fig. 2 ist die zweite Belegungsphase gemäß dem erfindungsgemäßen Verfahren anhand eines Diagramms dargestellt. Hierbei ist zu erkennen, dass die Dotierstoffkonzentration in oberflächennahen Bereichen verändert werden kann, ohne dass die Diffusionstiefe des Dotierstoffs verändert wird.

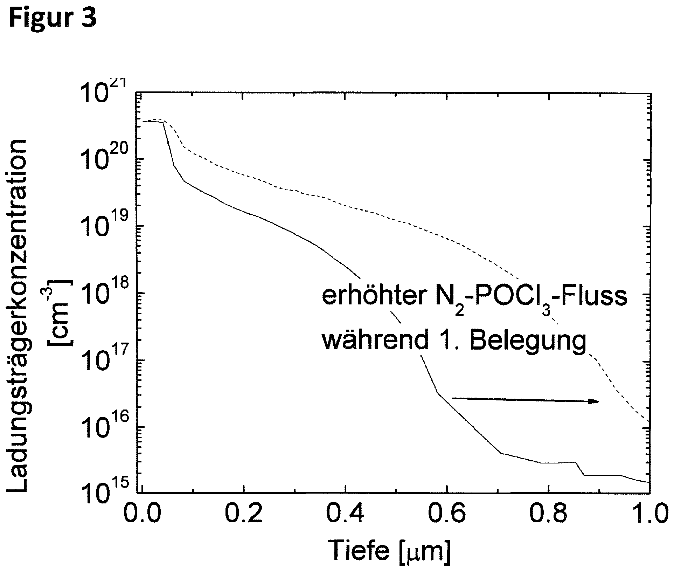

In Fig. 3 ist die erste Belegphase des erfindungsgemäßen Verfahrens anhand eines Diagramms dargestellt. Hieraus ist zu erkennen, dass durch die Erhöhung des Gasflusses der Dotierstoffquelle die Diffusionstiefe des Dotierstoffs verändert werden kann, ohne dass die Dotierstoffkonzentration in den oberflächennahen Bereichen beeinflusst wird.

### Beispiel

Silizium Wafer, z.B. mit einem Durchmesser von ca. 6 Zoll und planer Oberfläche werden unter Stickstoffatmosphäre in einem Rohrofen eingebracht. Daraufhin werden sie auf eine Temperatur von 950°C aufheizt. Während des ersten Teil des Hochrampens werden sie einer Gasatmosphäre aus N₂, O₂, und N₂-POCl₃ ausgesetzt. Im zweiten Teil des Hochrampens wurde dann der N₂-POCl₃ Fluss ausgestellt. Die Atmosphäre bestand somit aus N₂ und O₂. Während des Plateaus von 30 Minuten bei 950°C wurden die Wafer dann in reiner Stickstoffatmosphäre belassen. Im Anschluss an das Plateau wurde die Temperatur auf 880°C bis 830°C reduziert. Nach Erreichen dieser Temperatur wurden die Wafer abermals einer POCl₃-haltigen Atmosphäre ausgesetzt, wobei die Temperatur während dieser 10-30 min konstant blieb. Nach Abschluss dieser zweiten Belegung wurde das Rohr gespült und die Wafer aus dem Ofen entnommen. Die gezeigten Dotierprofile wurden mittels elektronischer Kapazitäts-Spannungs-Profilierung (ECV) nach Abnahme der Phosphorglasschicht gemessen.

## Patentansprüche

1. Verfahren zur Dotierung von Halbleitersubstraten mittels eines Diffusionsprozesses, bei dem
a) in einer ersten Belegungsphase auf einer Oberfläche eines Halbleitersubstrats zumindest bereichsweise mindestens eine Dotierstoffquelle abgeschieden wird,
b) in einer Eintreibphase mindestens ein Dotierstoff in das Halbleitersubstrat diffundiert,
c) in einer zweiten Belegungsphase zumindest bereichsweise auf dem Halbleitersubstrat die mindestens eine Dotierstoffquelle bei gleichzeitiger Diffusion von mindestens einem Dotierstoff in das Halbleitersubstrat erneut abgeschieden wird,
wobei die Diffusionstiefe des Dotierstoffs über den Gasfluss der Dotierstoffquelle in der ersten Belegungsphase und die Dotierstoffkonzentration im oberflächennahen Bereich des Halbleitersubstrats über den Gasfluss der Dotierstoffquelle in der zweiten Belegungsphase eingestellt wird,
**dadurch gekennzeichnet, dass** bei der Eintreibphase eine oxidierende Atmosphäre eingesetzt wird, was eine Umwandlung der Dotierstoffquelle bewirkt.

2. Verfahren nach Anspruch 1,
**dadurch gekennzeichnet, dass** die Dotierstoffkonzentration im oberflächennahen Bereich des Halbleitersubstrats unabhängig von der Diffusionstiefe des Dotierstoffs eingestellt wird.

3. Verfahren nach einem der vorhergehenden Ansprüche, **dadurch gekennzeichnet, dass**
a) im oberflächennahen Bereich des Halbleitersubstrats bis zu einer Tiefe, gemessen von der Oberfläche, von 5 nm eine Dotierstoffkonzentration von über 1.5·10²⁰ Atome/cm³, bevorzugt von über 3·10²⁰ Atome/cm³,
b) im Bereich einer Tiefe, gemessen von der Oberfläche, von 5 nm bis 100 nm eine Dotierstoffkonzentration von über 10¹⁷ Atome/cm³,
c) im Bereich einer Tiefe, gemessen von der Oberfläche, von 100 bis 400 nm eine Dotierstoffkonzentration von 10²⁰ Atome/cm³ bis 10¹⁷ Atome/cm³, bevorzugt im Bereich von 10¹⁹ Atome/cm³ bis 10¹⁷ Atome/cm³ erzeugt wird.

4. Verfahren nach einem der vorhergehenden Ansprüche,
**dadurch gekennzeichnet, dass** die erste Belegungsphase bei einer Temperatur im Bereich von 680 bis 950 °C, bevorzugt bei einer Temperatur im Bereich von 750 bis 850 °C, über einen Zeitraum von 5 bis 50 min, bevorzugt von 10 bis 30 min in inerter oder oxidierender Atmosphäre erfolgt.

5. Verfahren nach einem der vorhergehenden Ansprüche,
**dadurch gekennzeichnet, dass** die Eintreibphase bei einer Temperatur im Bereich von 700 bis 1000 °C, bevorzugt bei einer Temperatur im Bereich von 850 bis 950 °C, über einen Zeitraum von 30 bis 240 min, bevorzugt von 45 bis 150 min erfolgt.

6. Verfahren nach einem der vorhergehenden Ansprüche,
**dadurch gekennzeichnet, dass** die zweite Belegungsphase bei einer Temperatur im Bereich von 700 bis 950 °C, bevorzugt bei einer Temperatur im Bereich von 800 bis 900 °C, über einen Zeitraum von 5 bis 60 min, bevorzugt von 10 bis 30 min in inerter oder oxidierender Atmosphäre erfolgt.

7. Verfahren nach einem der vorhergehenden Ansprüche,
**dadurch gekennzeichnet, dass** die Diffusionstiefe des Dotierstoffs auch über eine zumindest bereichsweise Temperaturbehandlung des Halbleitersubstrats in einem Ofen in der ersten Eintreibphase eingestellt wird.

8. Verfahren nach einem der vorhergehenden Ansprüche,
**dadurch gekennzeichnet, dass** die erste Belegungsphase während des Aufheizens des Halbleitersubstrats von Raumtemperatur und/oder nach Erreichen einer Temperatur im Bereich von 750 bis 850 °C erfolgt.

9. Verfahren nach einem der vorhergehenden Ansprüche,
**dadurch gekennzeichnet, dass** in den einzelnen Phasen neben der Dotierstoffquelle weitere Gase, insbesondere Stickstoff und/oder Sauerstoff und/oder Wasserdampf eingeleitet werden.

10. Verfahren nach einem der vorhergehenden Ansprüche,
**dadurch gekennzeichnet, dass** für eine Dotierung mit Phosphor als Dotierstoffquelle POCl₃ und/oder PH₃ eingesetzt wird.

11. Verfahren nach einem der vorhergehenden Ansprüche,
**dadurch gekennzeichnet, dass** für eine Dotierung mit Bor die Dotierstoffquelle ausgewählt ist aus der Gruppe bestehend aus BBr₃, BCl₃, B₂H₆ und Mischungen hiervon.

12. Verfahren nach einem der vorhergehenden Ansprüche,
**dadurch gekennzeichnet, dass** vor der ersten Belegungsphase auf einer Oberfläche des Halbleitersubstrats ein erster Dotierstoff und auf der gegenüberliegenden Oberfläche des Halbleitersubstrats ein sich vom ersten Dotierstoff unterscheidender zweiter Dotierstoff abgeschieden wird und in der Eintreibphase der erste und der zweite Dotierstoff in das Halbleitersubstrat diffundieren.

13. Verfahren nach Anspruch 12,
**dadurch gekennzeichnet, dass** der erste Dotierstoff Bor und der zweite Dotierstoff Phosphor oder dass der erste Dotierstoff Phosphor und der zweite Dotierstoff Bor ist.

## Claims

1. A method for doping semiconductor substrates by means of a diffusion process, in which
a) in a first coating phase, at least one dopant source is deposited at least in regions on a surface of a semiconductor substrate,
b) in a drive-in phase, at least one dopant diffuses into the semiconductor substrate,
c) in a second coating phase, the at least one dopant source is deposited again at least in regions on the semiconductor substrate with simultaneous diffusion of at least one dopant into the semiconductor substrate,
wherein the diffusion depth of the dopant is set by means of the gas flow of the dopant source in the first coating phase and the dopant concentration in that region of the semiconductor substrate which is close to the surface by means of the gas flow of the dopant source in the second coating phase,
**characterised in that** in the drive-in phase an oxidising atmosphere is used, which brings about a transformation of the dopant source.

2. A method according to Claim 1,
**characterised in that** the dopant concentration **in that** region of the semiconductor substrate which is close to the surface is set independently of the diffusion depth of the dopant.

3. A method according to one of the preceding claims, **characterised in that**
a) **in that** region of the semiconductor substrate which is close to the surface up to a depth, measured from the surface, of 5 nm a dopant concentration of over 1.5 x 10²⁰ atoms/cm³, preferably of over 3 x 10²⁰ atoms/cm³, is produced,
b) in the region of a depth, measured from the surface, of 5 nm to 100 nm a dopant concentration of over 10¹⁷ atoms/cm³, is produced,
c) in the region of a depth, measured from the surface, of 100 to 400 nm a dopant concentration of 10²⁰ atoms/cm³ to 10¹⁷ atoms/cm³, preferably in the range of 10¹⁹ atoms/cm³ to 10¹⁷ atoms/cm³, is produced.

4. A method according to one of the preceding claims,
**characterised in that** the first coating phase takes place at a temperature in the range of 680 to 950°C, preferably at a temperature in the range of 750 to 850°C, over a period of 5 to 50 min, preferably of 10 to 30 min, in an inert or oxidising atmosphere.

5. A method according to one of the preceding claims,
**characterised in that** the drive-in phase takes place at a temperature in the range of 700 to 1000°C, preferably at a temperature in the range of 850 to 950°C, over a period of 30 to 240 min, preferably of 45 to 150 min.

6. A method according to one of the preceding claims,
**characterised in that** the second coating phase takes place at a temperature in the range of 700 to 950°C, preferably at a temperature in the range of 800 to 900°C, over a period of 5 to 60 min, preferably of 10 to 30 min, in an inert or oxidising atmosphere.

7. A method according to one of the preceding claims,
**characterised in that** the diffusion depth of the dopant is also set by means of a temperature treatment, at least in regions, of the semiconductor substrate in a furnace in the first drive-in phase.

8. A method according to one of the preceding claims,
**characterised in that** the first coating phase takes place during the heating-up of the semiconductor substrate from room temperature and/or after reaching a temperature in the range of 750 to 850°C.

9. A method according to one of the preceding claims,
**characterised in that** in the individual phases in addition to the dopant source further gases, in particular nitrogen and/or oxygen and/or steam, are introduced.

10. A method according to one of the preceding claims,
**characterised in that** for doping with phosphorus POCl₃ and/or PH₃ is used as dopant source.

11. A method according to one of the preceding claims,
**characterised in that** for doping with boron the dopant source is selected from the group consisting of BBr₃, BCl₃, B₂H₆ and mixtures thereof.

12. A method according to one of the preceding claims,
**characterised in that** prior to the first coating phase a first dopant is deposited on a surface of the semiconductor substrate and a second dopant which differs from the first dopant is deposited on the opposing surface of the semiconductor substrate, and in the drive-in phase the first and the second dopant diffuse into the semiconductor substrate.

13. A method according to Claim 12,
**characterised in that** the first dopant is boron and the second dopant is phosphorus, or **in that** the first dopant is phosphorus and the second dopant is boron.

## Revendications

1. Procédé pour le dopage de substrats semi-conducteurs à l'aide d'un procédé de diffusion, dans lequel
a) dans une première phase d'occupation sur une surface d'un substrat semi-conducteur, on dépose au moins par zones au moins une source de dopant,
b) dans une phase de redistribution, on diffuse au moins un dopant dans le substrat semi-conducteur,
c) dans une deuxième phase d'occupation, on dépose de nouveau par zones sur le substrat semi-conducteur l'au moins une source de dopant, avec simultanément diffusion d'au moins un dopant dans le substrat semi-conducteur,
la profondeur de diffusion du dopant étant ajustée dans la première phase d'occupation par l'intermédiaire du flux gazeux de la source de dopant, et la concentration du dopant dans la zone proche de la surface du substrat conducteur étant ajustée dans la deuxième phase d'occupation par l'intermédiaire du flux gazeux de la source de dopant,
**caractérisé en ce qu'**on utilise dans la phase de redistribution une atmosphère oxydante, qui provoque une transformation de la source de dopant.

2. Procédé selon la revendication 1, **caractérisé en ce que** la concentration du dopant dans la zone proche de la surface du substrat semi-conducteur est ajustée indépendamment de la profondeur de diffusion du dopant.

3. Procédé selon l'une des revendications précédentes, **caractérisé en ce qu'**on produit
a) dans la zone proche de la surface du substrat semi-conducteur, jusqu'à une profondeur, mesurée à partir de la surface, de 5 nm, une concentration du dopant supérieure à 1,5.10²⁰ atomes/cm³, de préférence supérieure à 3.10²⁰ atomes/cm³,
b) dans la zone d'une profondeur, mesurée à partir de la surface, de 5 nm à 100 nm, une concentration du dopant supérieure à 10¹⁷ atomes/cm³,
c) dans la zone d'une profondeur, mesurée à partir de la surface, de 100 à 400 nm, une concentration du dopant de 10²⁰ atomes/cm³ à 10¹⁷ atomes/cm³, de préférence comprise dans la plage de 10¹⁹ atomes/cm³ à 10¹⁷ atomes/cm³.

4. Procédé selon l'une des revendications précédentes, **caractérisé en ce que** la première phase d'occupation est réalisée à une température comprise dans la plage de 680 à 950 °C, de préférence à une température comprise dans la plage de 750 à 850 °C, sur une durée de 5 à 50 min, de préférence de 10 à 30 min, dans une atmosphère inerte ou oxydante.

5. Procédé selon l'une des revendications précédentes, **caractérisé en ce que** la phase de redistribution est réalisée à une température comprise dans la plage de 700 à 1000 °C, de préférence à une température comprise dans la plage de 850 à 950 °C, sur une durée de 30 à 240 min, de préférence de 45 à 150 min.

6. Procédé selon l'une des revendications précédentes, **caractérisé en ce que** la deuxième phase d'occupation est réalisée à une température comprise dans la plage de 700 à 950 °C, de préférence à une température comprise dans la plage de 800 à 900 °C, sur une durée de 5 à 60 min, de préférence de 10 à 30 min, dans une atmosphère inerte ou oxydante.

7. Procédé selon l'une des revendications précédentes, **caractérisé en ce que** la profondeur de diffusion du dopant est également ajustée par l'intermédiaire d'un traitement thermique, au moins par zones, du substrat semi-conducteur dans un four au cours de la première phase de redistribution.

8. Procédé selon l'une des revendications précédentes, **caractérisé en ce que** la première phase d'occupation est réalisée pendant la montée en température du substrat semi-conducteur à partir de la température ambiante, et/ou après qu'a été atteinte une température comprise dans la plage de 750 à 850 °C.

9. Procédé selon l'une des revendications précédentes, **caractérisé en ce que**, dans les différentes phases, et outre la source de dopant, on introduit des gaz supplémentaires, en particulier de l'azote et/ou de l'oxygène et/ou de la vapeur d'eau.

10. Procédé selon l'une des revendications précédentes, **caractérisé en ce qu'**on utilise, pour un dopage au phosphore, du POCl₃ et/ou du PH₃ en tant que source de dopant.

11. Procédé selon l'une des revendications précédentes, **caractérisé en ce que**, pour un dopage au bore, on choisit la source de dopant dans le groupe consistant en le BBr₃, le BCl₃, le B₂H₆ ou les mélanges de ceux-ci.

12. Procédé selon l'une des revendications précédentes, **caractérisé en ce que**, avant la première phase d'occupation, on dépose sur une surface du substrat semi-conducteur un premier dopant et sur la surface opposée du substrat semi-conducteur un deuxième dopant, différent du premier dopant, et, dans la phase de redistribution, on diffuse le premier et le deuxième dopants dans le substrat semi-conducteur.

13. Procédé selon la revendication 12, **caractérisé en ce que** le premier dopant est le bore et le deuxième dopant est le phosphore, ou que le premier dopant est le phosphore et le deuxième dopant est le bore.
